# FASCICULE DE BREVET EUROPEEN

(11) **EP 4 440 770 B1**
(45) Date de publication et mention de la délivrance du brevet: **04.11.2026**
(21) Numéro de dépôt: 22826600.3
(22) Date de dépôt: 02.12.2022
(51) Int. Cl.: B24B 13/00, G02B 1/10

(54) **SURFACE OPTIQUE D'UN MIROIR MÉTALLIQUE DE HAUTE PRÉCISION À TRÈS FAIBLES RUGOSITÉ ET DÉFAUT DE FORME**
OPTISCHE OBERFLÄCHE EINES HOCHPRÄZISEN METALLSPIEGELS MIT SEHR GERINGER RAUHEIT UND FORMDEFEKT
OPTICAL SURFACE OF A HIGH-PRECISION METAL MIRROR WITH VERY LOW ROUGHNESS AND SHAPE DEFECT

(30) Priorité: 02.12.2021 FR 2112744
(43) Date de publication de la demande: 09.10.2024
(73) Titulaire: Safran Reosc, 91280 Saint-Pierre-du-Perray (FR)
(72) Inventeur: LAGRANGE, Thierry, 77550 Moissy-Cramayel (FR); JOSEPH, Cédric, 77550 Moissy-Cramayel (FR); FOUCAUD, Guillaume, 77550 Moissy-Cramayel (FR); MERCERON, Jean-Marc, 77550 Moissy-Cramayel (FR); RODOLFO, Jacques, 77550 Moissy-Cramayel (FR)
(74) Mandataire: Regimbeau
(86) Numéro de dépôt international: PCT/FR2022/052228
(87) Numéro de publication internationale: WO 2023/099854

(56) Documents cités:
- FR-A1- 3 107 204
- US-A1- 2015 293 275

## Description

### DOMAINE DE TECHNIQUE

La présente demande concerne de manière générale le domaine du polissage d'une surface optique d'une pièce optique. La demande trouve notamment application dans la fabrication de miroirs métalliques de haute précision, pour des applications spatiales, astronomiques ou encore d'observations.

### ETAT DE LA TECHNIQUE

Les miroirs métalliques ont de nombreuses applications dans le domaine de l'optique.

De tels miroirs sont généralement obtenus en appliquant un revêtement métallique, typiquement en aluminium, sur un substrat composé d'un autre métal ou d'un autre matériau tel que le verre. Toutefois, lorsque ces miroirs sont soumis à des variations de température, comme c'est notamment le cas dans des applications spatiales et militaires, la surface du miroir subit des déformations différentielles (effet bimétallique).

Il a donc été proposé de polir la surface de substrats composés d'un seul métal ou alliage métallique. Cela évite effectivement les problèmes causés par les différences de propriétés thermiques. L'aluminium est un métal généralement privilégié pour la réalisation de tels miroirs en raison de sa faible densité, de son faible coût et de sa compatibilité avec les procédés de formage de surface conventionnels. Les performances de ces miroirs dans les applications optiques dépendent fortement de la surface devant être très uniforme pour minimiser la diffusion de la lumière causée par les irrégularités de la surface.

Les paramètres de rugosité de surface pertinents pour les performances optiques comprennent non seulement la rugosité de surface moyenne (Ra) ou la rugosité de surface moyenne quadratique (Rq), mais aussi des paramètres importants comprenant Rmax et/ou Rz. Rmax est la plus grande hauteur de pic à vallée dans une région d'échantillonnage donnée, où le pic représente un point haut sur la surface et la vallée représente la profondeur d'une rayure sur la surface.

Rz est une valeur moyenne de Rmax mesurée dans plusieurs régions d'échantillonnage distinctes. Non seulement la rugosité de surface moyenne doit être faible pour de bonnes performances optiques, mais également Rz, Rmax ou les paramètres associés doivent être faibles pour minimiser la diffusion de la lumière.

Il a également été proposé d'appliquer par électrodéposition une couche de nickel sur le substrat du miroir puis de polir la seconde couche métallique afin de réduire la diffusion de la lumière. Cependant, les miroirs obtenus étant composés de métaux différents, ils sont instables d'un point de vue mécanique et optique lors de variations de température.

On a également proposé de polir des surfaces en aluminium afin de réduire leur instabilité mécanique et optique. Deux méthodes sont couramment utilisées.

Dans le domaine de l'optique, le polissage est réalisé par usinage diamant afin de produire des miroirs en aluminium utiles pour réfléchir la lumière infrarouge (par exemple, à grande longueur d'onde). Dans le polissage diamant, un substrat en aluminium est mis en rotation tout en étant en contact avec un outil de coupe diamanté positionné avec précision sur la surface du substrat. L'outil de coupe diamanté « pèle » une très fine couche d'aluminium de la surface du substrat pour former une surface ayant une géométrie définie avec précision. Cependant, la rugosité obtenue dans un tel procédé est limitée à 5 nm RMS (root mean square en anglais, pour valeur quadratique moyenne) et ne permet pas d'obtenir des défauts de formes suffisants sur des surfaces non planes, et particulièrement des surfaces arbitraires (« freeform » en anglais).

Une amélioration du procédé d'usinage diamant consiste à déposer une couche de polissage sur le miroir et finir le polissage de cette couche. Le matériau régulièrement utilisé pour cette couche est du NiP (Kanigen) qui peut être poli à une bonne performance. Toutefois, ce matériau a un coefficient de dilatation thermique différent de l'aluminium utilisé pour le substrat, de sorte que le miroir est instable en température, ce qui rend difficile d'utilisation la solution.

Le polissage peut également être réalisé par rodage. Dans le rodage, une suspension de particules abrasives - généralement de l'oxyde d'aluminium ou du carbure de silicium dans un solvant comprenant de l'eau ou de l'huile - est utilisée pour polir une surface d'aluminium en déplaçant un pad par rapport à la surface d'aluminium afin d'entrainer la suspension abrasive et d'abraser la surface d'aluminium par action mécanique de l'abrasif. Cependant, le rodage génère des copeaux d'aluminium qui ont tendance à produire des micro-rayures sur la surface polie, conduisant à un défaut de surface inacceptable pour les applications optiques.

Le document FR3107204 décrit un procédé de fabrication de miroirs qui comporte une étape de construction par impression 3D sur un moule utilisant une technologie d'impression par dépôt de matière fondue. Le document US 2015/293275 décrit un procédé de revêtement de substrats au cours duquel un substrat est fraisé à une rugosité de surface comprise entre environ 60Å et environ 100Å RMS, poli, chauffé, puis subi un bombardement d'ions avec un gaz inerte.

### EXPOSE

Un but de la présente demande est de remédier aux inconvénients précités, en proposant un procédé de fabrication d'une surface optique d'une pièce optique métallique plane ou freeform permettant d'atteindre une rugosité de surface très faible, par exemple inférieure à deux nanomètres RMS, et un défaut de forme inférieur très faible, par exemple de l'ordre de 15 nm RMS, qui s'affranchisse des problématiques de déformation liées aux variations de température et puisse en particulier être utilisé à température cryogénique.

Le procédé s'applique notamment aux pièces optiques de grande dimension (typiquement 400 mm), de surface freeform et/ou de contour non circulaire.

Il est à cet effet proposé, selon un premier aspect, un procédé de fabrication d'une surface optique d'une pièce optique comprenant les étapes suivantes :
obtenir une pièce optique comprenant un substrat et un revêtement, le revêtement étant appliqué sur une face du substrat et étant configuré pour former une surface optique de la pièce optique, le substrat étant réalisé dans un premier alliage d'aluminium et le revêtement étant réalisé dans un deuxième alliage d'aluminium ayant une porosité inférieure à une porosité du premier alliage d'aluminium ;
déterminer un défaut de forme de référence et une rugosité de surface de référence de la surface optique, et un défaut de forme initial et une rugosité de surface initiale du revêtement ;
déterminer, à partir de la rugosité de surface initiale, des paramètres de polissage permettant d'obtenir la rugosité de surface de référence ;
en fonction des paramètres de polissages, usiner le revêtement de sorte à lui conférer un défaut de forme modifié ; et
polir le revêtement ainsi usiné par lissage conformément aux paramètres de polissage déterminés de sorte à modifier la rugosité de surface et le défaut de forme du revêtement, jusqu'à obtenir la rugosité de surface de référence et le défaut de forme de référence.

Certaines caractéristiques préférées mais non limitatives du procédé de fabrication selon le premier aspect sont les suivantes, prises individuellement ou en combinaison :
- l'étape d'usinage est réalisée par usinage ionique ou par finition magnétorhéologique ;
- l'étape de polissage est réalisée à l'aide d'un pad de polissage et d'un agent de polissage aqueux diamanté ;
- le procédé comprend en outre une étape de stabilisation thermique de la pièce optique ;
- l'étape de stabilisation thermique est réalisée préalablement à l'étape de détermination du défaut de forme initial et de la rugosité de surface initiale et/ou suite à l'étape de polissage ;
- le procédé comprend en outre une étape de nettoyage par application sans contact de vapeur d'eau sur la surface optique.
- le procédé comprend en outre une étape d'asséchage de la pièce optique sous vide suite à l'étape de nettoyage ;
- l'étape d'obtention de la pièce optique comprend une étape préalable d'usinage du substrat de sorte à obtenir un défaut de forme initial inférieur à une épaisseur initiale du revêtement et une rugosité initiale au plus égale à 15 nm RMS, par exemple 10 nm RMS ;
- le procédé comprend en outre : une étape de détermination de la rugosité de surface modifiée et du défaut de forme modifiés suite à l'étape de polissage ; et lorsque la rugosité de surface modifiée et/ou le défaut de forme modifié sont différents de la rugosité de surface de référence et/ou du défaut de forme de référence : la détermination de nouveaux paramètres de polissage afin d'obtenir la rugosité de surface de référence ; en fonction des nouveaux paramètres de polissages, l'usinage du revêtement de sorte à lui conférer un défaut de forme modifié ; et le polissage du revêtement ainsi usiné par lissage conformément aux nouveaux paramètres de polissage déterminés de sorte à modifier la rugosité de surface et le défaut de forme modifié du revêtement, jusqu'à obtenir la rugosité de surface de référence et le défaut de forme de référence.

Selon un deuxième aspect, il est proposé une pièce optique comprenant un substrat et une surface optique appliquée sur une face du substrat, le substrat étant réalisé dans un premier alliage d'aluminium et la surface optique étant réalisé dans un deuxième alliage d'aluminium ayant une porosité inférieure à une porosité du premier alliage d'aluminium et étant obtenue conformément à un procédé de fabrication selon le premier aspect.

Optionnellement, une rugosité de surface de la surface optique est inférieure ou égale à 2 nm RMS et un défaut de forme de la surface optique est inférieur ou égal à 15 nm RMS.

### DESCRIPTION DES FIGURES

D'autres caractéristiques, buts et avantages de l'invention ressortiront de la description qui suit, qui est purement illustrative et non limitative, et qui doit être lue en regard des dessins annexés sur lesquels :

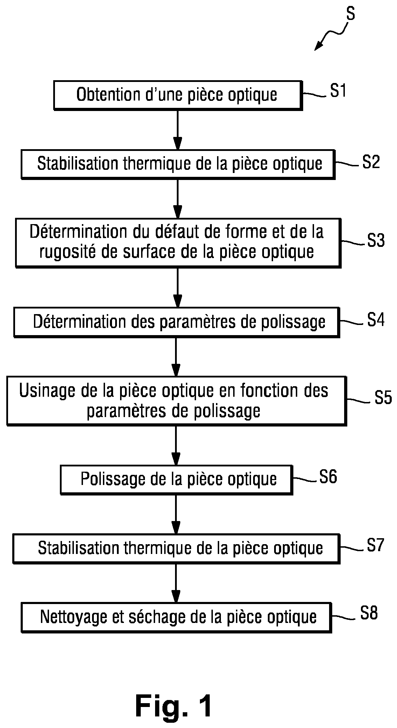

La figure 1 est un organigramme d'étapes d'un exemple de procédé de fabrication selon un mode de réalisation de l'invention ;
La figure 2a de manière très schématique illustre une pièce optique obtenue suite à l'étape S1 du procédé de fabrication ; et
La figure 2b illustre la pièce optique de la figure 2a après mise en oeuvre des étapes du procédé de fabrication.

Sur l'ensemble des figures, les éléments similaires portent des références identiques.

### DESCRIPTION DETAILLEE

Il est proposé ici un procédé de fabrication S de la surface optique 4 d'une pièce optique 1 permettant d'obtenir une rugosité de surface et un défaut de forme très faibles, même lorsque la pièce optique 1 est de grande dimension (typiquement 400 mm), de surface freeform (c'est-à-dire dont la surface présente un profil radial et des variations angulaires arbitraires) et/ou de contour non circulaire.

A cet effet, Il est proposé un procédé de fabrication S comprenant les étapes suivantes :
S1 :obtenir une pièce optique 1 comprenant un revêtement 2 sur un substrat 3, le revêtement 2 étant configuré pour former une surface optique 4 de la pièce optique 1 ;
S3 :déterminer un défaut de forme de référence et une rugosité de surface de référence de la surface optique 4, et un défaut de forme initial et une rugosité de surface initiale du revêtement 2 ;
S4 :déterminer, à partir de la rugosité de surface initiale, des paramètres de polissage permettant d'obtenir la rugosité de surface de référence ;
S5 :en fonction des paramètres de polissages, usiner (S5) le revêtement 2 de sorte à lui conférer un défaut de forme modifié ; et
S6 : polir le revêtement 2 ainsi usiné par lissage conformément aux paramètres de polissage déterminés de sorte à modifier la rugosité de surface et le défaut de forme du revêtement 2, jusqu'à obtenir la rugosité de surface de référence et le défaut de forme de référence.

Il est ainsi proposé de combiner une étape S5 d'usinage du revêtement 2, afin de réduire son défaut de forme, suivie d'une étape S6 de polissage par lissage, afin de réduire sa rugosité, pour obtenir la surface optique 4. De plus, l'étape S5 d'usinage est réalisée de sorte à tenir compte des déformations (inévitables) résultant de l'étape S6 ultérieure de polissage dont l'objectif est d'obtenir la rugosité de surface de référence désirée. L'étape S6 de polissage induit en effet nécessairement des défauts de forme sur revêtement 2 par effet de lissage. Or, comme nous le verrons par la suite, un tel effet de lissage (et donc le défaut de forme correspondant) peut être anticipé et donc pris en compte lors de l'étape S5 préalable d'usinage. Ainsi, le défaut de forme obtenu suite à l'étape S5 d'usinage ne correspond pas au défaut de forme de référence, qui est recherché pour la surface optique 4, mais à un défaut de forme intermédiaire, la forme du revêtement 2 étant ensuite modifiée par l'étape S6 de polissage. En revanche, suite à l'étape de polissage S6, le défaut de forme du revêtement 2 correspond au défaut de forme de référence recherché pour la surface optique 4.

Le défaut de forme de référence peut par exemple être inférieur ou égal à quinze nanomètres et la rugosité de surface de référence peut par exemple être inférieure ou égale à deux nanomètres, pour une surface optique 4 freeform dont la taille est de l'ordre de 400 mm.

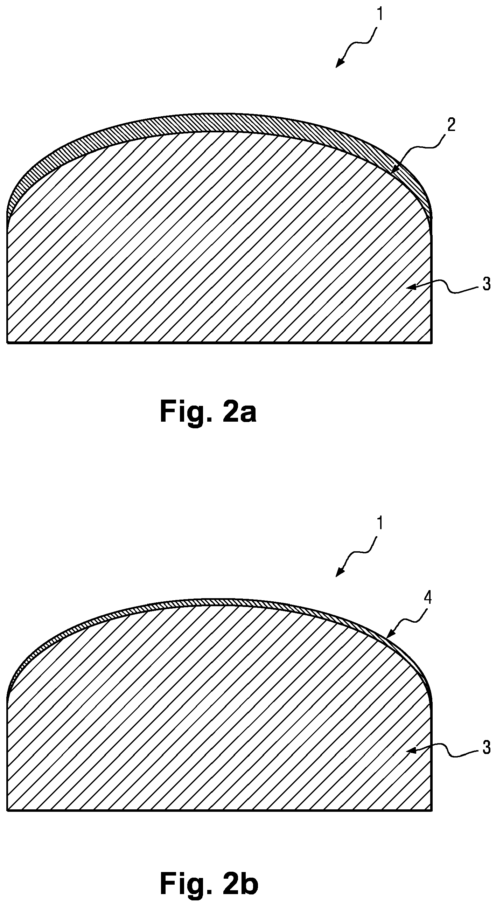

Au cours de l'étape S1, la pièce optique 1 est obtenue (figure 2a).

Le substrat 3 est réalisé dans un premier alliage d'aluminium présentant de bonnes performances mécaniques, et de préférence un coefficient de dilatation thermique similaire à celui du revêtement 2 (typiquement une différence de coefficient de dilatation thermique inférieure ) 5 x 10^-6 K^-1), par exemple l'un des alliages suivants : alliage d'aluminium 6061 (par exemple 6061-T6), 2017A, 2021 ou la famille d'alliages 70xx.

Le revêtement 2 est appliqué sur une face du substrat 3 et est monolithique avec le substrat 3. Le revêtement 2 est réalisé dans un deuxième alliage d'aluminium distinct du premier alliage d'aluminium. Le deuxième alliage est dense en ce qu'il présente une porosité inférieure à la porosité du premier alliage.

Par exemple, le deuxième alliage peut comprendre de l'aluminium pur à au moins 99% (déposé par évaporation sous vide). Le cas échéant, le revêtement 2 peut bien entendu être appliqué sur toutes les faces du substrat.

Le revêtement 2 peut être déposé par pulvérisation ou évaporation sur la face du substrat 3. Une épaisseur du revêtement 2 est par exemple comprise entre dix micromètres et vingt micromètres. Le défaut de forme de la pièce optique 1 est par ailleurs inférieur à l'épaisseur du revêtement 2, par exemple de l'ordre de 150 nm, typiquement de l'ordre de 100 nm pour un substrat 3 asphérique dont la taille moyenne est de 300 mm.

Lorsque le défaut de forme du substrat 3 est supérieur à l'épaisseur de revêtement à déposer, l'étape S1 comprend l'usinage du substrat 3 afin de réduire son défaut de forme. Cet usinage préalable S0 peut par exemple être réalisé par usinage diamant. On pourra par exemple se référer à l'article « Diamonds turn infrared mirrors smooth » de Daniel Vukobratovich et al., Optoelectronics World, pp. S25-S28, Octobre 1998 pour plus de détails sur ce type d'usinage.

Optionnellement, le procédé S comprend en outre une étape S2 de stabilisation thermique au cours de laquelle un traitement thermique est appliqué à la pièce optique 1 afin de la stabiliser thermiquement et d'éviter que la forme de la pièce évolue dans le temps et en fonction des variations de température.

Par exemple, un traitement thermique comprenant plusieurs cycles de traitement thermiques est réalisé pendant au moins deux heures chacun, par exemple pendant trois à cinq heures chacun, où la température appliquée à la pièce optique 1 va d'une première température au plus égale à - 50°C, par exemple égale à - 80°C, à une deuxième température au moins égale à + 120°C, par exemple + 150°C à chaque cycle, de préférence sous atmosphère sèche pour éviter la dégradation de rugosité. A chaque cycle, la température est maintenue à la première température pendant une durée prédéterminée, par exemple entre une trentaine de minutes et deux heures, puis augmente progressivement jusqu'à atteindre la deuxième température, par exemple suivant une rampe de température égale à + 2°/min ; la température est stabilisée à la deuxième température pendant une durée prédéterminée, par exemple entre une trentaine de minutes et deux heures, avant de diminuer progressivement jusqu'à la première température, typiquement suivant une rampe de température égale à - 2°/min. Un total de six cycles (2h à - 50°C, 1h de phase transitoire, 2h à + 120°C, 1h de phase transitoire) peuvent par exemple être réalisés, soit un traitement thermique de 39 h.

Un autre exemple de traitement thermique de stabilisation pouvant être appliqué ici est décrit dans le document « The primary mirror of the ARIEL mission: study of thermal, figuring, and finishing treatments and optical characterization of AI 6061 samples mirrors », Chioetto et al., Proc. SPIE 11116, Astronomical Optics: Design, Manufacture, and Test of Space and Ground Systems II, 111161C.

Cette étape S2 peut ne pas être réalisée lorsque la pièce optique 1 obtenue à l'étape S1 est déjà stable thermiquement.

Au cours de l'étape S3, le défaut de forme initial et la rugosité de surface initiale du revêtement 2 sont déterminés. Cette étape peut être réalisée par exemple à l'aide d'un interféromètre pour la mesure du défaut de forme et rugosimètre optique pour la mesure de rugosité.

Au cours de l'étape S4, les paramètres de polissage permettant d'obtenir la rugosité de surface de référence sont déterminés à partir de la rugosité de surface initiale.

Les paramètres de polissage peuvent comprendre l'un au moins des paramètres suivants : la vitesse de rotation et d'avance du pad de polissage, le nombre de cycles de polissage nécessaires pour passer de la rugosité de surface initiale à la rugosité de surface de référence, le parcours (généralement aléatoire) du pad de polissage sur le revêtement 2, les caractéristiques physiques du pad de polissage, les caractéristiques physiques de l'abrasif de polissage, la pression appliquée par le pad de polissage sur le revêtement 2, le deuxième alliage métallique.

La dégradation du défaut de forme par polissage étant connue pour chaque cycle de polissage en fonction de ces paramètres de polissage, une machine de commande numérique peut ainsi calculer une fonction d'usure à partir des paramètres de polissage permettant de déterminer le nombre de cycles de polissage nécessaires pour réduire la rugosité de surface du revêtement 2 et atteindre la rugosité de surface de référence, et en déduire la déformation (effet de lissage) qui sera subie par la pièce optique 1 lors de l'étape de polissage.

Optionnellement, le procédé S peut comprendre une étape préalable de calibration du polissage afin de déterminer les paramètres de polissage. A cet effet, l'outillage de lissage peut être appliqué sur une pièce optique 1 identique, c'est-à-dire présentant un substrat 3 et un revêtement 2 sensiblement identiques à ceux de la pièce optique 1 à fabriquer, afin de calibrer la déformation induite par l'outillage de lissage sur le revêtement 2.

Au cours de l'étape S5, une machine de commande numérique détermine les paramètres d'usinage du revêtement 2 et envoie des instructions d'usinage du revêtement 2 à un outillage d'usinage afin d'obtenir un défaut de forme modifié du revêtement 2.

Le défaut de forme modifié correspond à un défaut de forme intermédiaire, obtenu suite à l'étape d'usinage et préalablement à l'étape S6 de polissage. Ce défaut de forme intermédiaire prend en compte la déformation du revêtement 2 inhérente à l'étape S6 ultérieure de polissage de sorte que, une fois les étapes d'usinage et de polissage réalisées, le défaut de forme obtenu corresponde au défaut de forme de référence. En d'autres termes, le défaut de forme de référence correspond à la somme du défaut de forme modifié (intermédiaire) et de la déformation résultant de l'étape de polissage (effet de lissage).

La prise en compte de la déformation résultant de l'étape S6 ultérieure de polissage est nécessaire lorsqu'on cherche à obtenir un défaut de forme très faible, typiquement inférieur ou égal à 15 nm RMS.

Dans un mode de réalisation, l'étape S5 est réalisée par usinage ionique à l'aide d'un canon à ions dans un environnement sous vide. Le canon à ions peut par exemple comprendre un robot multiaxes (typiquement, 6 axes) sur lequel est monté une source d'ions générant un faisceau d'ions ayant une énergie comprise entre 800 eV et 1500 eV et présentant une largeur à mi-hauteur comprise entre 5 mm et 25 mm.

En variante, l'étape S5 peut être réalisée par finition magnétorhéologique à l'aide d'une machine MRF (acronyme anglais de magneto-rheological finishing), au cours de laquelle un flux magnétique est appliqué à un fluide de polissage chargé de particules magnétiques et appliqué sur le revêtement 2. Le fluide de polissage forme alors un outil de polissage permettant d'usiner par cisaillement le revêtement 2 et de retoucher son défaut de forme.

Au cours de l'étape S6, le revêtement 2 est poli par lissage. Cette étape de polissage a pour effet de modifier la rugosité de surface et le défaut de forme du revêtement 2 et est réalisée conformément aux paramètres de polissage déterminés à l'étape S4 jusqu'à l'obtention de la rugosité de surface de référence et le défaut de forme de référence (figure 2b).

L'étape de polissage peut par exemple être réalisée avec un outil de lissage comprenant un diamètre compris entre 10 mm et 50 mm suivant la forme de la face du substrat 3 de la pièce optique 1, par exemple de l'ordre de 20 mm. L'outil de lissage doit être suffisamment rigide pour réduire la rugosité du revêtement 2 et suffisamment déformable pour suivre la forme de la face du substrat 3 qui porte le revêtement 2, afin de limiter (voire supprimer) les risques de dégradation du substrat 3. L'outil de lissage peut par exemple comprendre un disque en laiton mince (typiquement d'un millimètre d'épaisseur). Un pad de polissage est en outre monté sur l'outil de lissage et un agent de polissage (abrasif) comprenant un solvant dans lequel sont suspendues des particules abrasives, typiquement à base de diamant, est appliqué sur le revêtement 2. Le pad de polissage est configuré pour accrocher les particules de l'agent de polissage afin de les entrainer de manière homogène lors de la rotation et du balayage de l'outil de polissage sur le revêtement 2, sans pour autant rayer le revêtement 2. C'est donc l'agent de polissage qui réduit la rugosité de surface du revêtement 2. Le pad de polissage peut par exemple comprendre un tissu fibreux ou une feutrine. L'agent de polissage peut être à base d'eau.

L'outil de lissage peut par exemple appliquer une pression de l'ordre de 2 kg pour un outil de diamètre 20 mm sur le revêtement 2. La vitesse de rotation de l'outil de polissage peut être de l'ordre de 500 tr/min. Le parcours de l'outil de lissage est choisi pour ne pas générer de singularités sur la pièce et peut typiquement être aléatoire, comme décrit par exemple dans l'article « Pseudo-random tool paths for CNC sub-aperture polishing and othe applications » de Christina R. Dunn et al., OSA Vol. 16, No. 23 / OPTICS EXPRESS 18942.

Une fois l'étape S6 de polissage réalisée conformément aux paramètres de polissage identifiés à l'étape S4, la pièce optique 1 présente alors une surface optique 4 dont le défaut de forme et la rugosité de surface correspondent au défaut de forme de référence et à la rugosité de surface de référence.

Lorsque la rugosité de surface et/ou le défaut de forme obtenus suite à l'étape S6 de polissage ne correspondent pas à la rugosité de surface de référence et/ou au défaut de forme de référence, les étapes S3 à S6 sont réitérées. En particulier, de nouveaux paramètres de polissage et d'usinage sont déterminés afin d'obtenir la rugosité de surface de référence et le défaut de surface de référence à partir de la rugosité de surface et du défaut de forme obtenus suite à l'étape S6, puis le revêtement est usiné S5 et poli S6 conformément aux nouveaux paramètres de polissage jusqu'à obtenir la rugosité de surface de référence et le défaut de forme de référence.

Les étapes S5 d'usinage et S6 de polissage sont susceptibles de provoquer un relâchement des contraintes dans le substrat 3 ou dans le revêtement 2 de la pièce optique 1, qui induit une déformation de la pièce. Afin de supprimer cette déformation, le procédé S peut en outre comprendre une étape S7 de stabilisation thermique au cours de laquelle un traitement thermique est appliqué à la pièce optique 1 obtenue suite à l'étape S6 de polissage. Ce traitement thermique permet ainsi de supprimer les déformations liées au relâchement de contraintes dans la pièce optique 1 et de la stabiliser thermiquement afin d'éviter que la forme de la pièce optique 1 n'évolue dans le temps et/ou en fonction de la température.

Par exemple, un traitement thermique comprenant plusieurs cycles de traitement thermiques est réalisé pendant au moins deux heures, par exemple pendant deux à quatre heures. En particulier, le même traitement thermique de stabilisation que celui décrit dans l'étape S2 peut être appliqué à l'étape S7. La pièce optique 1 est alors stable et s'affranchit en particulier des problématiques de déformation liées aux variations de température. Elle peut en particulier être utilisée à température cryogénique.

Cette étape peut en revanche optionnelle lorsque les applications envisagées pour la pièce optique 1 sont à température ambiante.

Au cours d'une étape S8, la pièce optique 1 est nettoyée puis séchée. De préférence, le nettoyage et le séchage sont réalisés sans contact pour ne pas rayer la surface optique 4.

Le nettoyage et le séchage peuvent être conventionnels. En variante, afin de ne pas abîmer la surface optique 4, et en particulier de ne pas dégrader le défaut de forme ni la rugosité de surface obtenus à l'étape S6, l'étape de nettoyage peut être réalisée par application sans contact de vapeur d'eau sur la surface optique 4. La vapeur d'eau peut comprendre un mélange d'eau de ville et d'eau désionisée, par exemple en proportion 10/90.

Le séchage peut être réalisé par mise sous vide (10^-2 bar) de la pièce optique 1 pendant 5h avec un gaz inerte comprimé, par exemple un gaz comprimé comprenant de l'azote.

## Revendications

1. Procédé de fabrication (S) d'une surface optique (4) d'une pièce optique (1) comprenant les étapes suivantes :
obtenir (S1) une pièce optique (1) comprenant un substrat (3) et un revêtement (2), le revêtement (2) étant appliqué sur une face du substrat (3) et étant configuré pour former une surface optique (4) de la pièce optique (1), le substrat (3) étant réalisé dans un premier alliage d'aluminium et le revêtement (2) étant réalisé dans un deuxième alliage d'aluminium, le procédé **caractérisé par** le deuxième alliage d'aluminium ayant une porosité inférieure à une porosité du premier alliage d'aluminium ;
ainsi que **caractérisé par** les étapes suivantes:
déterminer (S3) un défaut de forme de référence et une rugosité de surface de référence de la surface optique (4), et un défaut de forme initial et une rugosité de surface initiale du revêtement (2) ;
déterminer (S4), à partir de la rugosité de surface initiale, des paramètres de polissage permettant d'obtenir la rugosité de surface de référence ;
en fonction des paramètres de polissage, usiner (S5) le revêtement (2) de sorte à lui conférer un défaut de forme modifié ; et
polir (S6) le revêtement (2) ainsi usiné par lissage conformément aux paramètres de polissage déterminés de sorte à modifier la rugosité de surface et le défaut de forme du revêtement (2), jusqu'à obtenir la rugosité de surface de référence et le défaut de forme de référence.

2. Procédé de fabrication (S) selon la revendication 1, dans lequel l'étape d'usinage (S5) est réalisée par usinage ionique ou par finition magnétorhéologique.

3. Procédé de fabrication (S) selon l'une des revendications 1 et 2, dans lequel l'étape de polissage (S6) est réalisée à l'aide d'un pad de polissage et d'un agent de polissage aqueux diamanté.

4. Procédé de fabrication (S) selon l'une des revendications 1 à 3, comprenant en outre une étape de stabilisation thermique de la pièce optique (1) (S2, S7).

5. Procédé de fabrication (S) selon la revendication 4, dans lequel l'étape (S2, S7) de stabilisation thermique est réalisée préalablement à l'étape (S3) de détermination du défaut de forme initial et de la rugosité de surface initiale et/ou suite à l'étape de polissage (S6).

6. Procédé de fabrication (S) selon l'une des revendications 1 à 5, comprenant en outre une étape (S8) de nettoyage par application sans contact de vapeur d'eau sur la surface optique (4).

7. Procédé de fabrication (S) selon la revendication 6, comprenant en outre une étape (S8) d'asséchage de la pièce optique (1) sous vide suite à l'étape de nettoyage.

8. Procédé de fabrication (S) selon l'une des revendications 1 à 7, dans lequel l'étape (S1) d'obtention de la pièce optique (1) comprend une étape préalable (S0) d'usinage du substrat (3) de sorte à obtenir un défaut de forme initial inférieur à une épaisseur initiale du revêtement (2) et une rugosité initiale au plus égale à 15 nm RMS, par exemple 10 nm RMS.

9. Procédé de fabrication (S) selon l'une des revendications 1 à 8, comprenant en outre :
une étape de détermination de la rugosité de surface modifiée et du défaut de forme modifiés suite à l'étape de polissage (S6) ; et
lorsque la rugosité de surface modifiée et/ou le défaut de forme modifié sont différents de la rugosité de surface de référence et/ou du défaut de forme de référence : la détermination de nouveaux paramètres de polissage afin d'obtenir la rugosité de surface de référence ; en fonction des nouveaux paramètres de polissage,
l'usinage (S5) du revêtement (2) de sorte à lui conférer un défaut de forme modifié ; et le polissage (S6) du revêtement (2) ainsi usiné par lissage conformément aux nouveaux paramètres de polissage déterminés de sorte à modifier la rugosité de surface et le défaut de forme modifié du revêtement (2), jusqu'à obtenir la rugosité de surface de référence et le défaut de forme de référence.

10. Pièce optique (1) comprenant un substrat (3) et une surface optique (4) appliquée sur une face du substrat (3), le substrat (3) étant réalisé dans un premier alliage d'aluminium et la surface optique (4) étant realisée dans un deuxième alliage d'aluminium, la pièce optique **caractérisée par** le deuxième alliage d'aluminium ayant une porosité inférieure à une porosité du premier alliage d'aluminium et étant obtenue conformément à un procédé de fabrication (S) selon l'une des revendications 1 à 9.

11. Pièce optique (1) selon la revendication 10, dans lequel une rugosité de surface de la surface optique (4) est inférieure ou égale à 2 nm RMS et un défaut de forme de la surface optique (4) est inférieur ou égal à 15 nm RMS.

## Patentansprüche

1. Verfahren (S) zur Herstellung einer optischen Oberfläche (4) eines optischen Bauteils (1), das die folgenden Schritte umfasst:
Erhalten (S1) eines optischen Bauteils (1), das ein Substrat (3) und eine Beschichtung (2) umfasst, wobei die Beschichtung (2) auf einer Seite des Substrats (3) aufgebracht und so konfiguriert ist, dass sie eine optische Oberfläche (4) des optischen Bauteils (1) bildet, wobei das Substrat (3) aus einer ersten Aluminiumlegierung hergestellt ist und die Beschichtung (2) aus einer zweiten Aluminiumlegierung hergestellt ist, wobei das Verfahren **dadurch gekennzeichnet ist, dass** die zweite Aluminiumlegierung eine Porosität aufweist, die unter einer Porosität der ersten Aluminiumlegierung liegt; sowie durch die folgenden Schritte gekennzeichnet ist:
Bestimmen (S3) eines Referenz-Formfehlers und einer Referenz-Oberflächenrauhigkeit der optischen Oberfläche (4) und eines anfänglichen Formfehlers und einer anfänglichen Oberflächenrauhigkeit der Beschichtung (2);
Bestimmen (S4) der Polierparameter anhand der anfänglichen Oberflächenrauheit, mit denen die Referenz-Oberflächenrauhigkeit erreicht werden kann;
Bearbeiten (S5) der Beschichtung (2) entsprechend den Polierparametern, um ihr einen veränderten Formfehler zu verleihen; und
Polieren (S6) der so bearbeitete Beschichtung (2) durch Glätten gemäß den bestimmten Polierparametern, um die Oberflächenrauhigkeit und den Formfehler der Beschichtung (2) zu verändern, bis die Referenz-Oberflächenrauhigkeit und der Referenz-Formfehler erreicht sind.

2. Herstellungsverfahren (S) nach Anspruch 1, wobei der Bearbeitungsschritt (S5) durch Ionenbearbeitung oder durch magnetorheologische Endbearbeitung durchgeführt wird.

3. Herstellungsverfahren (S) nach einem der Ansprüche 1 und 2, wobei der Polierschritt (S6) unter Verwendung eines Polierpads und eines wässrigen Diamantpoliermittels durchgeführt wird.

4. Herstellungsverfahren (S) nach einem der Ansprüche 1 bis 3, das ferner einen Schritt des thermischen Stabilisierens des optischen Bauteils (1) (S2, S7) umfasst.

5. Herstellungsverfahren (S) nach Anspruch 4, wobei der Schritt (S2, S7) des thermischen Stabilisierens vor dem Schritt (S3) des Bestimmens des anfänglichen Formfehlers und der anfänglichen Oberflächenrauhigkeit und/oder im Anschluss an den Polierschritt (S6) durchgeführt wird.

6. Herstellungsverfahren (S) nach einem der Ansprüche 1 bis 5, das ferner einen Reinigungsschritt (S8) durch berührungsloses Aufbringen von Wasserdampf auf die optische Oberfläche (4) umfasst.

7. Herstellungsverfahren (S) nach Anspruch 6, das ferner einen Trocknungsschritt (S8) des optischen Teils (1) im Vakuum im Anschluss an den Reinigungsschritt umfasst.

8. Herstellungsverfahren (S) nach einem der Ansprüche 1 bis 7, wobei der Schritt (S1) des Erhaltens des optischen Bauteils (1) einen vorbereitenden Schritt (S0) des Bearbeitens des Substrats (3) umfasst, um einen anfänglichen Formfehler zu erhalten, der kleiner als eine anfängliche Dicke der Beschichtung (2) ist und eine anfängliche Rauheit von höchstens gleich 15 nm RMS, beispielsweise von 10 nm RMS.

9. Herstellungsverfahren (S) nach einem der Ansprüche 1 bis 8, das ferner umfasst:
einen Schritt des Bestimmens der veränderten Oberflächenrauhigkeit und des veränderten Formfehlers nach dem Polierschritt (S6); und,
wenn die veränderte Oberflächenrauhigkeit und/oder der veränderte Formfehler von der Referenz-Oberflächenrauhigkeit und/oder dem Referenz-Formfehler abweichen: das Bestimmen neuer Polierparameter, um in Abhängigkeit von den neuen Polierparametern die Referenz-Oberflächenrauhigkeit zu erreichen,
das Bearbeiten (S5) der Beschichtung (2), um ihr einen veränderten Formfehler zu verleihen; und das Polieren (S6) der so bearbeiteten Beschichtung (2) durch Glätten gemäß den bestimmten neuen Polierparametern, um die Oberflächenrauhigkeit und den veränderten Formfehler der Beschichtung (2) zu verändern, bis die Referenz-Oberflächenrauhigkeit und der Referenz-Formfehler erreicht sind.

10. Optisches Bauteil (1), umfassend ein Substrat (3) und eine optische Oberfläche (4), die auf einer Seite des Substrats (3) aufgebracht ist, wobei das Substrat (3) aus einer ersten Aluminiumlegierung hergestellt ist und die optische Oberfläche (4) aus einer zweiten Aluminiumlegierung hergestellt ist, wobei das optische Bauteil durch die zweite Aluminiumlegierung gekennzeichnet ist, die eine Porosität aufweist, die unter der Porosität der ersten Aluminiumlegierung liegt und gemäß einem Herstellungsverfahren (S) nach einem der Ansprüche 1 bis 9 erhalten wird.

11. Optisches Bauteil (1) nach Anspruch 10, wobei eine Oberflächenrauhigkeit der optischen Oberfläche (4) kleiner oder gleich 2 nm RMS ist und ein Formfehler der optischen Oberfläche (4) kleiner oder gleich 15 nm RMS ist.

## Claims

1. A method of manufacture (S) of an optical surface (4) of an optical part (1) comprising the following steps:
obtaining (S1) an optical part (1) comprising a substrate (3) and a coating (2), the coating (2) being applied onto one surface of the substrate (3) and being configured to form an optical surface (4) of the optical part (1), the substrate (3) being made of a first aluminium alloy and the coating (2) being made of a second aluminium alloy, the method being **characterized by** the second aluminium alloy having lesser porosity than a porosity of the first aluminium alloy and by the following steps;
determining (S3) a reference shape defect and a reference surface roughness of the optical surface (4), and an initial shape defect and initial surface roughness of the coating (2);
determining (S4), from the initial surface roughness, polishing parameters allowing the reference surface roughness to be obtained;
depending on the polishing parameters, machining (S5) the coating (2) to impart thereto a modified shape defect; and
polishing (S6) the machined coating (2) by smoothening according to the determined polishing parameters, to modify the surface roughness and shape defect of the coating (2), until the reference roughness and reference shape defect are obtained.

2. The method of manufacture (S) according to claim 1, wherein the machining step (S5) is performed by ion-beam machining or by magnetorheological finishing.

3. The method of manufacture (S) according to one of claims 1 and 2, wherein the polishing step (S6) is performed with a polishing pad and an aqueous diamond polishing agent.

4. The method of manufacture (S) according to one of claims 1 to 3, further comprising a thermal stabilization step (S2, S7) of the optical part (1).

5. The method of manufacture (S) according to claim 4, wherein the thermal stabilization step (S2, S7) is performed before the step (S3) to determine the initial shape defect and initial surface roughness and/or after the polishing step (S6).

6. The method of manufacture (S) according to one of claims 1 to 5, further comprising a cleaning step (S8) by contactless application of water vapour to the optical surface (4).

7. The method of manufacture (S) according to claim 6, further comprising a vacuum drying step (S8) of the optical part (1) after the cleaning step.

8. The method of manufacture (S) according to one of claims 1 to 7, wherein the step (S1) to obtain the optical part (1) comprises a prior machining step (S0) of the substrate (3) to obtain an initial shape defect smaller than an initial thickness of the coating (2) and an initial roughness of no more than 15 nm RMS, for example 10 nm RMS.

9. The method of manufacture (S) according to one of claims 1 to 8, further comprising:
a step to determine the modified surface roughness and modified shape defect after the polishing step (S6); and
if the modified surface roughness and/or modified shape defect differ from the reference surface roughness and/or reference shape defect: determining new polishing parameters to obtain the reference surface roughness; depending on the new polishing parameters, machining (S5) the coating (2) to impart thereto a modified shape defect; and polishing (S6) the machined coating (2) by smoothening according to the determined new polishing parameters, to modify the surface roughness and modified shape defect of the coating (2), until the reference surface roughness and reference shape defect are obtained.

10. An optical part (1) comprising a substrate (3) and an optical surface (4) applied to a surface of the substrate (3), the substrate (3) being made of a first aluminium alloy and the optical surface (4) being made of a second aluminium alloy, the optical part being **characterized by** the second aluminium alloy having lesser porosity than the porosity of the first aluminium alloy and by being obtained according to the method of manufacture (S) according to one of claims 1 to 9.

11. The optical part (1) according to claim 10, wherein a surface roughness of the optical surface (4) is less than or equal to 2 nm RMS, and a shape defect of the optical surface (4) is less than or equal to15 nm RMS.
